# EUROPÄISCHE PATENTANMELDUNG

(11) **EP 0 751 576 A2**
(43) Veröffentlichungstag der Anmeldung: **02.01.1997**
(21) Anmeldenummer: 96110440.3
(22) Anmeldetag: 28.06.1996
(51) Int. Cl.: H01L 31/042, H01L 31/048, B60R 16/02, H02J 7/00

(54) **Schaltungsanordnung von Solarzellen**

(30) Priorität: 30.06.1995 DE 19523904; 28.07.1995 DE 19527740
(71) Anmelder: Webasto Systemkomponenten GmbH, 82131 Stockdorf (DE)
(72) Erfinder: Wecker, Reinhard, 82223 Eichenau (DE)
(74) Vertreter: Wiese, Gerhard

(57) **Zusammenfassung**

Die Erfindung betrifft eine Schaltungsanordnung mit einer ersten Reihenschaltung (A) von Solarzellen, wobei die von den Solarzellen erzeugte elektrische Energie zum Betrieb einer ohmschen oder induktiven Last (L) dient. Im Unterschied zu bekannten Schaltungsanordnungen, bei denen die in einer Parallelschaltung zusammengefaßten Reihenschaltungen eine etwa gleich große Leerlaufspannung aufweisen ist erfindungsgemäß vorgesehen, daß die Reihenschaltungen (A,B) zur Anpassung an die Strom/Spannungs-Charakteristik der Last (L) auf eine unterschiedliche erzeugbare Leerlaufspannung (Uₒ) ausgelegt sind. Vorzugsweise sind in der oder den Reihenschaltungen (A) mit einer niedrigeren Leerlaufspannung Rückstrom-Sperrdiode(n) (16) angeordnet. Die Reihenschaltung mit einer niedrigeren Leerlaufspannung kann wahlweise bei Solarzellen gleicher Leerlaufspannung von einer niedrigeren Anzahl oder auch bei Solarzellen unterschiedlicher Leistung von einer gleich großen Anzahl von Solarzellen mit der niedrigeren Leerlaufspannung gebildet werden. Es wird ferner eine Schaltungsanordnung zum wahlweisen Betreiben einer Lüfteranordnung oder zum Laden einer Batterie durch wechselweises Verschalten mehrerer Strings von Solarzellen in Form einer Parallel-oder einer Reihenschaltung angegeben.

## Beschreibung

Die Erfindung betrifft eine Schaltungsanordnung mit einer ersten Reihenschaltung von Solarzellen und wenigstens einer dazu parallel geschalteten zweiten Reihenschaltung von Solarzellen, wobei die von den Solarzellen erzeugte elektrische Energie zum Betrieb einer ohmschen oder induktiven Last dient.

Eine derartige Schaltungsanordnung ist aus der DE-C1 41 05 389 für die Erzeugung von Solarstrom in einem Schiebedachdeckel für den Betrieb eines fahrzeugeigenen Gebläses bekannt. Dabei besteht die erste der Reihenschaltungen aus Solarzellen mit kristallinem Halbleiterwerkstoff und die zweite Reihenschaltung aus Solarzellen mit amorphem Halbleiterwerkstoff Beide Gruppen sind dort so ausgelegt, daß die in ihnen erzeugte Spannung jeweils zumindestens näherungsweise die gleiche ist. Die Leerlaufspannungen der Solarzellen liegen im Bereich von 0,4 - 0,6 Volt. Innerhalb beider Reihenschaltungen werden jeweils soviele Solarzellen hintereinander geschaltet, daß eine möglichst gleiche Spannung anliegt. Zur Erzeugung höherer Ströme sind die beiden Reihenschaltungen dann durch eine Parallelschaltung verbunden. Nachteilig bei den bekannten Schaltungsanordnungen daß sie an ohmsche oder induktive Lasten nicht optimal anzupassen sind. Insbesondere beim Betrieb von Gleichstrommotoren besteht das Problem, daß entweder die insgesamt von den Solarzellen erzeugbare elektrische Leistung so hoch ausgelegt sein muß, daß sie auch bei niedrigerer Sonneneinstrahlung bereits den erhöhten Anlaufstrom eines solchen Elektromotors aufbringen oder aber andernfalls in Kauf zu nehmen, daß der Motor erst nahe der maximalen auf die Solarzellen einwirkenden Sonneneinstrahlung überhaupt anläuft. Man hat versucht, diesem Problem in der Vergangenheit durch den Einsatz sogenannter DC/DC-Wandler abzuhelfen, bei denen durch aufwendige elektronische Schaltungen der maximale Leistungspunkt zu einer niedrigeren Spannung hin verschoben wird. Derartige elektronische Schaltungen sind jedoch zum einen relativ teuer und verbrauchen darüber hinaus selbst einen Teil der von den Solarzellen erzeugten elektrischen Energie.

Der Erfindung liegt die Aufgabe zugrunde, eine Schaltungsanordnung zu schaffen, die mit einfachen Mitteln eine optimale Anpassung der von Solarzellen erzeugten elektrischen Leistung an die von einem ohmschen oder induktiven Verbraucher benötigte Leistung gestattet.

Diese Aufgabe wird erfindungsgemäß durch die im kennzeichnenden Teil des Patentanspruchs 1 angegebenen Mittel gelöst. Vorteilhafte Ausgestaltungen der Erfindung sind den Unteransprüchen zu entnehmen.

Dadurch, daß die in den einzelnen Reihenschaltungen erzeugbare Leerlaufspannung bewußt unterschiedlich ausgelegt ist, wobei die auch als Strings bezeichneten Reihenschaltungen von Solarzellen mit einer niedrigeren Leerlaufspannung vorzugsweise durch Rückstrom-Sperrdioden geschützt werden, entsteht durch die Parallelschaltung dieser Strings mit unterschiedlicher Leerlaufspannung eine Leistungskennlinie der gesamten Schaltungsanordnung, die der Leistungskennlinie ohmscher oder induktiver Verbraucher sehr gut angenähert werden kann. Der Leistungsabfall an den optional vorhandenen Sperrdioden ist dabei deutlich niedriger als der durch Einsatz eines DC/DC-Wandlers verursachte Leistungsverlust. Durch den Verzicht auf einen derartigen DC/DC-Wandler können die Kosten für eine Schaltungsanordnung, die beispielsweise zur Erzeugung von Solarstrom im Deckel eines Schiebehebedaches angeordnet ist, deutlich gesenkt werden.

Für eine derartige Schaltungsanordnung bieten sich verschiedene Alternativen der Realisierung an. So kann gemäß einer Ausführungsform jede der Reihenschaltungen aus gleichen Anzahlen von Solarzellen zusammengesetzt sein, wobei die Solarzellen der ersten Reihenschaltung jeweils eine niedrigere Leerlaufspannung aufweisen als die der zweiten Reihenschaltung.

Gemäß einer anderen alternativen Ausgestaltungsform können sich die Reihenschaltungen aus unterschiedlichen Anzahlen von Solarzellen mit gleicher Leerlaufspannung zusammensetzen. Schließlich sind ebensogut Mischformen denkbar, wobei im Ergebnis immer die gesamte in einer Reihenschaltung entstehende Leerlaufspannung sich von der der anderen Reihenschaltungen nennenswert unterscheidet.

Unabhängig von der Zusammensetzung der einzelnen Reihenschaltungen ist es vorteilhaft für eine gleichzeitige Nutzung der Schaltungsanordnung zum Betrieb einer ohmschen oder induktiven Last oder zum Aufladen einer Batterie, wenn diese einen Umschalter aufweist, mittels dem alle Reihenschaltungen ihrerseits in Reihe schaltbar sind. Eine derartige Reihenschaltung aller einzelnen Strings von Solarzellen trägt dem Umstand Rechnung, daß eine Batterie in einem weiten Leistungsbereich von etwa 10% bis 100% Ladung bei einer annähernd gleichen Spannung arbeitet, sodaß hierbei keine Anpassung der Kennlinie erforderlich ist.

Gemäß einer vorteilhaften Verwendung ist vorgesehen, daß die Schaltungsanordnung mit ihren Solarzellen im Bereich eines Deckels eines öffnungsfähigen Fahrzeugdachs angeordnet ist und daß die Last von einem Motor eines im Fahrzeug angeordneten Gebläses gebildet wird.

Bei einer solchen Verwendung einer Schaltungsanordnung kann vorteilhaft die aus dem eingangs genannten Stand der Technik bekannte Aufteilung eines solchen Deckels in amorphe Solarzellen, die im zentralen Bereich des Deckels angeordnet sind und in kristalline Solarzellen, die in einem undurchsichtigen, die Deckelmechanik abdeckenden Randbereich angeordnet sind mit ihren unterschiedlichen Leerlaufspannungen sinnvoll kombiniert werden.

Zur Minimierung der Verlustleistungen ist es vorteilhaft, wenn die Rückstrom-Sperrdiode(n) von einer Schottky-Diode gebildet wird/werden.

Nachfolgend ist ein Ausführungsbeispiel der Erfindung anhand der Zeichnung erläutert und den Nachteilen beim Stand der Technik gegenüber gestellt. Es zeigt:
- Fig. 1: eine schematische Darstellung eines Fahrzeugs,
- Fig. 2: eine Draufsicht auf den Deckel des Fahrzeugdachs,
- Fig. 3: einen Schnitt durch den Randbereich des Deckels,
- Fig. 4: eine schematische Darstellung einer erfindungsgemäßen Schaltungsanordnung,
- Fig. 5: ein Strom/Spannungsdiagramm einer bekannten Parallelschaltung von Strings gleicher Leerlaufspannung,
- Fig. 6: eine Leistungskurve einer bekannten Parallelschaltung von Strings gleicher Leerlaufspannung,
- Fig. 7: eine Leistungskurve einer bekannten mit einem DC/DC-Wandler ausgestatteten Schaltungsanordnung,
- Fig. 8: die Leistungskennlinien einer erfindungsgemäßen Schaltungsanordnung im Vergleich zu einer mit einem DC/DC-Wandler ausgestatteten Schaltungsanordnung,
- Fig. 9a und b: die Strom/Spannungs-Kennlinie dreier Strings mit unterschiedlicher Leerlaufspannung,
- Fig. 10: die Strom/Spannungs-Kennlinie der drei parallel geschalteten Strings,
- Fig. 11: die Strom/Spannungs-Kennlinie einer erfindungsgemäßen Schaltungsanordnung im Vergleich mit der Kennlinie eines Lüftermotors und
- Fig. 12: eine Schaltungsanordnung mit einem Umschalter für eine Reihenschaltung aller Strings.

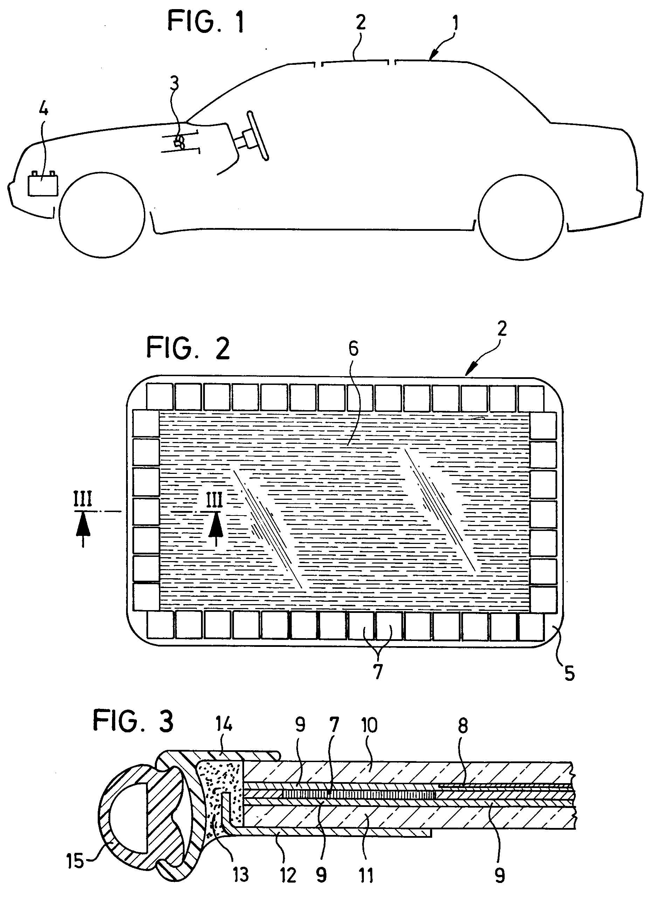

In Fig. 1 ist ein Fahrzeugdach 1 mit einem Deckel 2 versehen, der eine nicht näher bezeichnete Dachöffnung wahlweise verschließt oder zumindestens teilweise freilegt. Das Fahrzeug ist ferner in üblicher Weise mit einem Gebläse 3 zur Zufuhr von Frischluft und/oder Umluft zum Fahrzeuginnenraum sowie mit einer Batterie 4 ausgestattet.

Wie aus Fig. 2 ersichtlich, ist der Deckel 2 als Solarglasdeckel ausgebildet, und umfaßt einen umlaufenden Randbereich 5 sowie einen von diesem umschlossenen zentralen Bereich 6. Unter dem Randbereich 5 sind die üblicherweise zur Anlenkung der Bewegungsmechanik des Deckels 2 erforderlichen Blechteile wie Deckelinnenblech und eventuell Kulissen angeordnet, sodaß der Randbereich 5 vorzugsweise von oben her undurchsichtig gehalten ist. Aus diesem Grund sind die im Randbereich 5 angeordneten Solarzellen als kristalline Solarzellen 7 ausgebildet. Dagegen ist im zentralen Bereich 6 des Deckels 2 eine Transparenz des Deckels 2 erwünscht, weshalb hier amorphe Solarzellen 8 zum Einsatz gelangen.

Wie der Teilschnitt gemäß Fig. 3 verdeutlicht, setzt sich der Deckel 2 aus einer oberen Scheibe 10 und einer unteren Scheibe 11 zusammen, zwischen denen die kristallinen Solarzellen 7 im Randbereich 5 bzw. die amorphen Solarzellen 8 im zentralen Bereich 6 mittels Klebefolien 9 eingebettet sind. Das der Verstärkung des Deckels 2 im Randbereich dienende Deckelinnenblech 12 ist ebenso wie ein den Deckel 2 am Umfang umgebender Kunststoffrahmen 14 mittels einer Kunststoff-Vergußmasse 13 am Deckel 2 befestigt. Eine außen am Kunststoffrahmen 14 umlaufende Nut dient zur Aufnahme einer Dichtung 15.

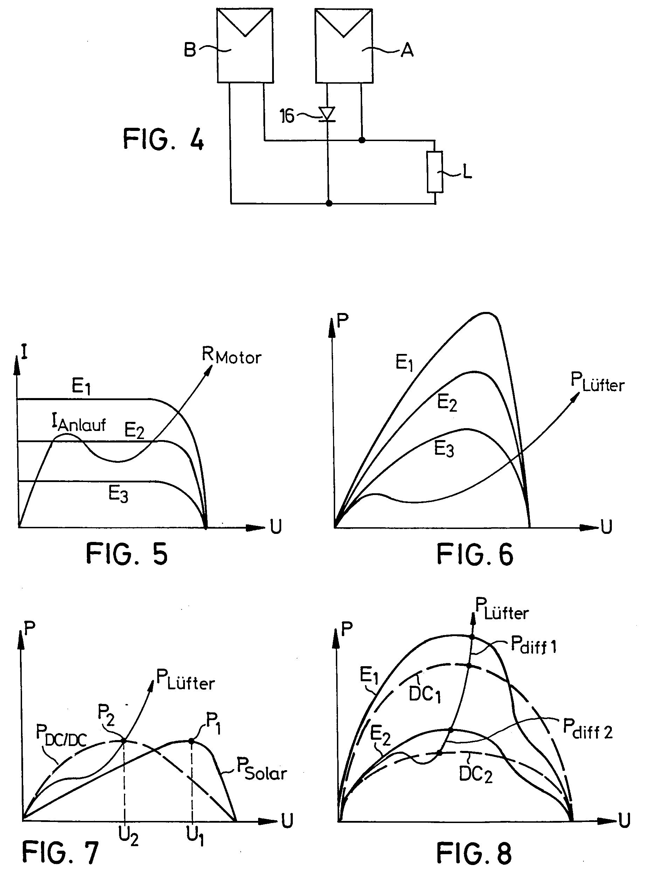

In Fig. 4 sind zwei verschiedene Arrays oder Strings als Reihenschaltung A bzw. B von Solarzellen unterschiedlicher Leerlaufspannung Uₒ in einer Parallelschaltung an eine ohmsche und/oder induktive Last L angeschlossen. Jeder String A bzw. B ist dabei wiederum für sich gesehen als Reihenschaltung einer Anzahl von Solarzellen 8 bzw. 7 ausgebildet. Im Beispiel gemäß Fig. 4 wird der String bzw. die erste Reihenschaltung A von den amorphen Solarzellen 8 des Deckels 2 gebildet. Der andere String, bzw. die zweite Reihenschaltung B wird von den kristallinen Solarzellen 7 im Randbereich 5 des Deckels 2 gebildet. Es wird von einer in etwa gleich großen Anzahl von Solarzellen 8 bzw. 7 ausgegangen, sodaß der String bzw. die erste Reihenschaltung A aufgrund der niedrigeren Leerlaufspannung Uₒ der amorphen Solarzellen 8 auch insgesamt eine niedrigere Leerlaufspannung Uₒ bereitstellt, als der aus den leistungsfähigeren kristallinen Solarzellen 7 zusammengesetzte String B. Die erste Reihenschaltung A ist in Stromrichtung zum Verknüpfungspunkt der Parallelschaltung hin durch eine Rückstrom-Sperrdiode 16 geschützt, die vorzugsweise als Schottky-Diode ausgebildet ist. Auf den Einsatz von Rückstrom-Sperrdioden 16 kann unter Umständen verzichtet werden, falls aufgrund der Kennlinien der einzelnen Reihenschaltungen keine oder nur minimale Rückströme im Bereich des Arbeitspunktes der ohmschen oder induktiven Last L auftreten. Die Last L wird vom Motor des Gebläses 3 gebildet.

Im Strom/Spannungs-Diagramm gemäß Fig. 5 ist zum einen die Kennlinie eines solchen für ein Gebläse 3 verwendeten Motors und zum anderen die Kennlinie einer herkömmlichen Parallelschaltung von Strings gleicher Leerlaufspannung gegenüber gestellt. Hieraus zeigt sich, daß aufgrund des erforderlichen relativ hohen Anlaufstromes des Motors bei einer niedrigeren Sonnenenergie-Einstrahlung E₃ bzw. auch der nächst höheren Einstrahlung E₂ kein Anlaufen des Motors erfolgen würde. Erst bei der maximalen Einstrahlung E₁ wird von einer solchen Parallelschaltung von Strings der erforderliche Anlaufstrom aufgebracht. Dies hat den Nachteil, daß die von den Solarzellen eines Schiebedachdeckels erzeugte Leistung im Falle einer gewünschten Standentlüftung eines Fahrzeuges beispielsweise bei ausgestelltem Deckel 2 erst bei einer maximalen Sonneneinstrahlung zu einem Entlüftungseffekt für den Fahrzeuginnenraum führt. Um dem zu begegnen, wurde bei einer anderen Auslegung, die in Fig. 6 dargestellt ein derartiges Verhältnis der Leistungen der verwendeten Solarzellen und der Kennlinie eines Lüftermotors gewählt, daß der Anlaufstrom des Lüftermotors bereits bei einer relativ niedrigen Einstrahlungsdichte E₃ überwunden wird. Dies wiederum hat jedoch den Nachteil, daß bei einer maximalen Einstrahlung E₁ ein großer Teil der Leistung verschenkt wird oder der Lüftermotor im Falle des Fehlens von Schutzmaßnahmen überlastet wäre und beschädigt werden könnte.

Man hat bei einer anderen bekannten Anordnung gemäß Fig. 7 versucht, durch Einsatz eines DC/DC-Wandlers den Leistungshöhepunkt einer Solarzellenschaltung vom Punkt P₁ mit der dort zugeordneten größeren Spannung U₁ auf einen Punkt P₂ mit einer entsprechend niedrigeren Spannung U₂ zu verschieben. Mittels einer solchen Verschiebung läßt sich der Anlaufstrom eines Lüftermotors bereits bei einer niedrigeren Einstrahlungsdichte überwinden und die maximale Leistung P₂ der Solarzellen kann dennoch zum Betrieb des Lüfters eingesetzt werden. Derartige DC/DC-Wandler haben jedoch den Nachteil, daß sie mit einem Stückpreis von etwa DM 50,-- pro Schiebedachdeckel relativ teuer sind und daß sie zum anderen einen Teil der erzeugten Solarleistung selbst benötigen.

In Fig. 8 ist im Leistungs/Spannungs-Diagramm die erfindungsgemäß unsymmetrische Verschaltung einer herkömmlichen, mit einem DC/DC-Wandler ausgestatteten Schaltung gegenübergestellt. Hieraus wird ersichtlich, daß bei einer niedrigeren Sonneneinstrahlungsintensität E₂ aufgrund des Eigenverbrauchs des DC/DC-Wandlers die Leistungskurve DC₂ nicht ausreicht, um den Anlaufstrom des Lüftermotors aufzubringen. Dem gegenüber weist die oberhalb dieser Kurve liegende Kurve, die der Leistung einer unsymmetrischen Parallelschaltung von Solarzellen gemäß der Erfindung entspricht, eine um den Betrag Pdiff₂ höhere Leistung auf, welche für das Anlaufen des Lüftermotors ausreichend ist. Bei einer maximalen Einstrahlungsdichte E₁ im oberen Teil der Fig. 8 wird ebenfalls deutlich, daß die ganz oben liegende Kurve, die der Leistung der erfindungsgemäßen unsymmetrischen Parallelschaltung von Solarzellen entspricht, eine höhere Lüfterleistung ermöglicht, als die aufgrund des Eigenverbrauchs des DC/DC-Wandlers darunter liegende Kurve DC₁. Der Differenzbetrag der Leistung zugunsten der erfindungsgemäßen Schaltung ist mit Pdiff₁ bezeichnet.

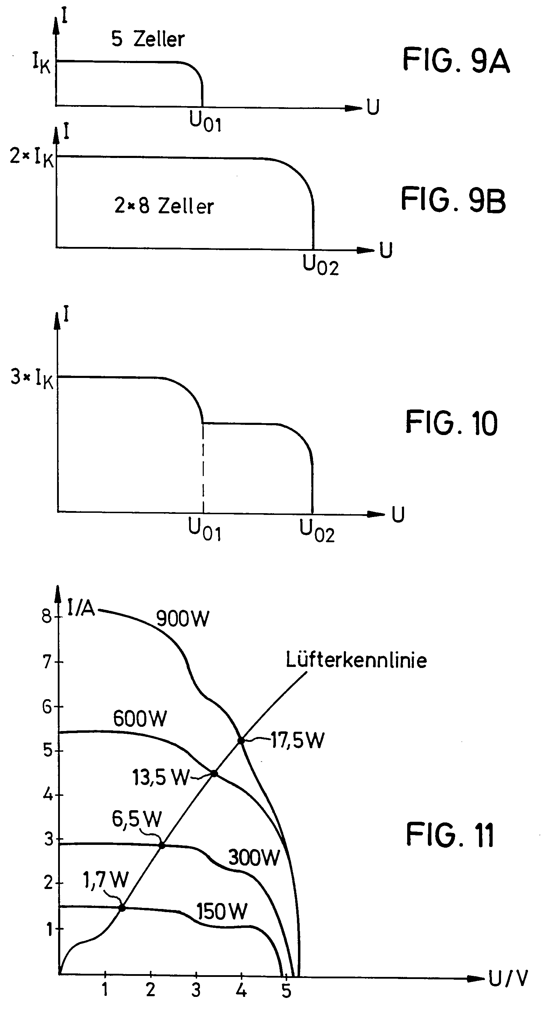

Wie bereits eingangs angedeutet, kann die Erfindung auf mehrfache Weise realisiert werden. So kann die erste Reihenschaltung A mit niedrigerer Leerlaufspannung U₀ bei gleicher Leerlaufspannung der einzelnen Zellen durch eine niedrigere Anzahl von in Reihe geschalteten Zellen erzeugt werden oder aber bei unterschiedlicher Zellenspannung auch durch eine gleiche Anzahl von Zellen, wie sie in der zweiten Reihenschaltung B verwendet wird. Dazwischen sind auch Mischformen denkbar, wobei immer eine von mindestens zwei Reihenschaltungen oder Strings eine signifikant niedrigere Leerlaufspannung U₀ aufweist. In den Fig. 9A und 9B ist ein Ausführungsbeispiel in Strom/Spannungs-Diagrammen dargestellt, bei dem Solarzellen gleicher Leerlaufspannung in einem String A gemäß Fig. 9A zu einer ersten Reihenschaltung von fünf Zellen zusammengeschaltet sind. Gemäß Fig. 9B wird die zweite Reihenschaltung B von einer Reihenschaltung aus zwei je acht in Reihe geschaltete Zellen gleicher Leerlaufspannungen gebildet. Werden diese beiden Strings A und B aus den Fign. 9A bzw. 9B in einer Parallelschaltung zusammengeschaltet, so ergibt sich eine Strom/Spannungs-Kennlinie gemäß Fig. 10. Wie in Fig. 11 dargestellt, ist eine solche unsymmetrische Parallelschaltung von Strings unterschiedlicher Leerlaufspannung bestens geeignet, die von den Solarzellen bei unterschiedlicher Einstrahlungsintensität bereit gestellte Leistung in nahezu idealer Weise an eine Lüfterkennlinie anzupassen. Hierzu können beliebige Anzahlen von Reihenschaltungen zu einer Parallelschaltung zusammengefaßt werden. Die Erfindung ist somit nicht auf die bislang dargestellte Parallelschaltung aus nur zwei Reihenschaltungen A bzw. B beschränkt.

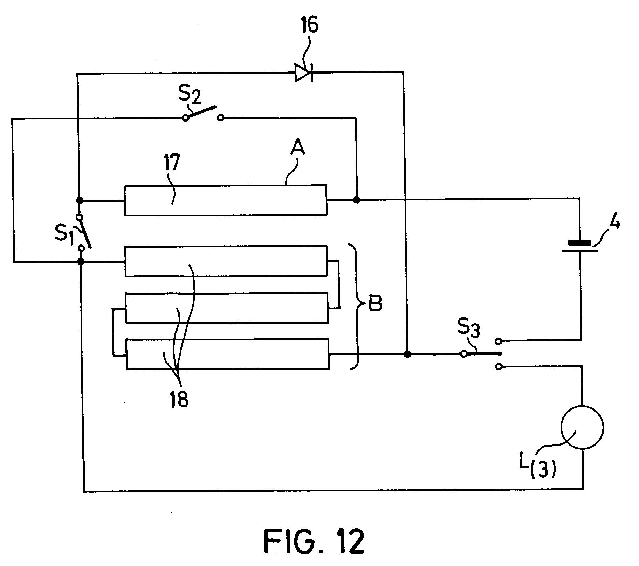

Im Ausführungsbeispiel gemäß Fig. 12 ist ein aus neun Solarzellen in Reihe bestehender String 17 als erste Reihenschaltung A und eine aus drei solchen Strings 18 mit jeweils neun in Reihe geschalteten Solarzellen bestehende zweite Reihenschaltung B vorhanden, die durch Schalter S₁, S₂ und S₃ wahlweise zum Betrieb einer ohmschen und/oder induktiven Last L, wie beispielsweise des Motors des Gebläses 3, oder zum Laden der Fahrzeugbatterie 4 verwendbar sind. Zum Betrieb des Gebläses 3, d.h. der Last L ist der Schalter S₁ geöffnet und der Schalter S₂ geschlossen. Der als Umschalter ausgebildete Schalter S₃ liegt am Anschlußpol der Last L an. Hierdurch sind die Reihenschaltungen A und B in Form einer Parallelschaltung zusammengeschaltet, die in der vorstehend beschriebenen vorteilhaften Weise zur Anpassung an die Kennlinie der Last L für deren optimalen Betrieb verwendbar ist.

Soll hingegen die Fahrzeugbatterie 4 aufgeladen werden, so wird der Schalter S₁ geschlossen und der Schalter S₂ geöffnet sowie der Umschalter S₃ an den Anschlußpol der Batterie 4 angelegt. Hierdurch sind beide Reihenschaltungen A bzw. B mit allen vier aus je neun Solarzellen bestehenden Strings 17 bzw. 18 in Form einer Reihenschaltung zusammengefaßt und erzeugen eine konstant hohe für das Laden der Batterie 4 erforderliche Spannung.

Selbstverständlich können die Schalter S₁, S₂ und S₃ in Form eines einzigen Schaltelements oder auch eines in Abhängigkeit vom Ladezustand der Batterie 4 betätigbaren Relais ausgeführt sein.

### Bezugszeichenliste

- 1: Fahrzeugdach
- 2: Deckel
- 3: Gebläse
- 4: Batterie
- 5: Randbereich (von 2)
- 6: zentraler Bereich (von 2)
- 7: kristalline Solarzellen
- 8: amorphe Solarzellen
- 9: Klebefolien
- 10: obere Scheibe
- 11: untere Scheibe
- 12: Deckelinnenblech
- 13: Vergußmasse
- 14: Kunststoffrahmen
- 15: Dichtung
- 16: Rückstrom-Sperrdiode
- 17: Solarzellen - Strings
- 18: Solarzellen - Strings
- A: erste Reihenschaltung
- B: zweite Reihenschaltung
- S₁: Schalter
- S₂: Schalter
- S₃: Schalter
- L: Last
- Uₒ: Leerlaufspannung

## Patentansprüche

1. Schaltungsanordnung mit einer ersten Reihenschaltung (A) von Solarzellen und wenigstens einer dazu parallel geschalteten zweiten Reihenschaltung (B) von Solarzellen, wobei die von den Solarzellen erzeugte elektrische Energie zum Betrieb einer ohmschen oder induktiven Last (L) dient, **dadurch gekennzeichnet**, daß die Reihenschaltungen (A,B) zur Anpassung an die Strom/Spannungs-Charakteristik der Last (L) auf eine unterschiedliche erzeugbare Leerlaufspannung (Uₒ) ausgelegt sind

2. Schaltungsanordnung nach Anspruch 1, **dadurch gekennzeichnet**, daß in der oder den Reihenschaltung(en) (A) mit einer niedrigeren Leerlaufspannung (Uₒ) Rückstrom-Sperrdiode(n)(16) angeordnet ist/sind.

3. Schaltungsanordnung nach Anspruch 1 oder 2, **dadurch gekennzeichnet**, daß die Reihenschaltungen (A,B) aus gleichen Anzahlen von Solarzellen zusammen gesetzt sind, wobei die Solarzellen der ersten Reihenschaltung (A) jeweils eine niedrigere Leerlaufspannung (Uₒ) aufweisen als die der zweiten Reihenschaltung (B).

4. Schaltungsanordnung nach Anspruch 1 oder 2, **dadurch gekennzeichnet**, daß die Reihenschaltungen (A,B) aus unterschiedlichen Anzahlen von Solarzellen (S2) zusammengesetzt sind, wobei jede Solarzelle die gleiche Leerlaufspannung (Uₒ) aufweist.

5. Schaltungsanordnung nach einem der vorhergehenden Ansprüche, **dadurch gekennzeichnet**, daß sie einen Umschalter (S₁,S₂,S₃) enthält, mittels dem alle Reihenschaltungen (A,B) ihrerseits in Reihe schaltbar sind.

6. Schaltungsanordnung nach einem der vorhergehenden Ansprüche, **dadurch gekennzeichnet**, daß die Solarzellen im Bereich eines Deckels (2) eines öffnungsfähigen Fahrzeugdachs (1) angeordnet sind und daß die Last (L) von einem Motor eines im Fahrzeug angeordneten Gebläses (3) gebildet wird.

7. Schaltungsanordnung nach Anspruch 5 und 6, **dadurch gekennzeichnet**, daß die nach Betätigung des Umschalters (S₁,S₂,S₃) bestehende Reihenschaltung aus mehreren Reihenschaltungen (A,B) zur Ladung einer im Fahrzeug angeordneten Batterie (4) verwendet wird.

8. Schaltungsanordnung nach Anspruch 3 und Anspruch 6 bis 7, **dadurch gekennzeichnet**, daß die Solarzellen der ersten Reihenschaltung (A) von amorphen Solarzellen (8) gebildet werden, die im zentralen Bereich (6) des Deckels (2) angeordnet sind und daß die Solarzellen der zweiten Reihenschaltung (B) von kristallinen Solarzellen (7) gebildet werden, die im Randbereich (5) des Deckels (2) angeordnet sind.

9. Schaltungsanordnung nach einem der vorhergehenden Ansprüche 2 bis 8, **dadurch gekennzeichnet**, daß die Rückstrom-Sperrdiode (16) von einer Schottky-Diode gebildet wird.
